# EUROPEAN PATENT APPLICATION

(11) **EP 4 521 454 A1**
(43) Date of publication of application: **12.03.2025**
(21) Application number: 23820012.5
(22) Date of filing: 17.05.2023
(51) Int. Cl.: H01L 23/13, H05K 3/34, H05K 1/11, H01L 23/00, H01L 23/31, H01L 21/56, H05K 1/18, H01L 25/065

(54) **SEMICONDUCTOR PACKAGE INCLUDING RESIN, AND ELECTRONIC DEVICE COMPRISING SAME**

(30) Priority: 07.06.2022 KR 20220068828; 09.08.2022 KR 20220099193
(71) Applicant: Samsung Electronics Co., Ltd., Suwon-si, Gyeonggi-do 16677 (KR)
(72) Inventor: SONG, Chagyu, Suwon-si Gyeonggi-do 16677 (KR); SEO, Hoyeon, Suwon-si Gyeonggi-do 16677 (KR); RA, Jaeyeon, Suwon-si Gyeonggi-do 16677 (KR); PARK, Kookjin, Suwon-si Gyeonggi-do 16677 (KR); PARK, Chulwoo, Suwon-si Gyeonggi-do 16677 (KR); SHIN, Dongjun, Suwon-si Gyeonggi-do 16677 (KR); LEE, Jongbum, Suwon-si Gyeonggi-do 16677 (KR); JIN, Gyeongmin, Suwon-si Gyeonggi-do 16677 (KR)
(74) Representative: HGF
(86) International application number: PCT/KR2023/006716
(87) International publication number: WO 2023/239076

(57) **Abstract**

An electronic device according to an embodiment comprises: a printed circuit board including a first side and a second side perpendicular to the first side; a plurality of solder balls arranged on one surface of the printed circuit board to be spaced apart from the first side and the second side; an electronic component including at least one circuit and disposed on at least some of the plurality of solder balls; and a resin disposed along the first side and filling a part of the space arranged between the one surface of the printed circuit board and the electronic component, wherein the printed circuit board includes a blocking structure disposed between the plurality of solder balls and the first side and extending along the first side to space at least some of the plurality of solder balls and the resin apart from each other.

## Description

### [Technical Field]

The present disclosure relates to a semiconductor package including a resin and an electronic device including the same.

### [Background Art]

An electronic device may include various electronic components to provide various functions to a user. As the miniaturization of the electronic device, an electronic component may be disposed in the electronic device in a form of a semiconductor package. The semiconductor package may include a printed circuit board and the electronic component disposed on the printed circuit board. For example, the electronic component may be electrically connected to the printed circuit board through a soldering process.

### [Disclosure]

### [Technical Problem]

As a solder ball is disposed between an electronic component and a printed circuit board, a space may be formed between the electronic component and the printed circuit board. A resin may be disposed in the space between the electronic component and the printed circuit board to protect the electronic component. In case that the resin is contacted to the solder ball, damage to the solder ball may occur due to a difference in physical properties between the resin and the solder ball, and thus the electronic component may not perform a pre-designed function. The electronic device and the semiconductor package may require a structure in which the solder ball and the resin are spaced apart from each other.

The technical problems to be solved in this document are not limited to those described above, and other technical problems not mentioned herein will be clearly understood by those having ordinary knowledge in the art to which the present disclosure belongs, from the following description.

### [Technical Solution]

According to an embodiment, an electronic device may comprise a printed circuit board including a first side and a second side perpendicular to the first side, a plurality of solder balls, disposed on a surface of the printed circuit board, and spaced apart from the first side and the second side, an electronic component, including at least one circuit, and disposed on at least some of the plurality of solder balls, and a resin, disposed along the first side, and filling a portion of a space disposed between the surface of the printed circuit board and the electronic component, and wherein the printed circuit board may include a blocking structure, disposed between the plurality of solder balls and the first side, and extending along the first side to separate at least some of the plurality of solder balls from the resin.

According to an embodiment, a semiconductor package may comprise a printed circuit board including a first side and a second side perpendicular to the first side, a plurality of solder balls, disposed on a surface of the printed circuit board, and spaced apart from the first side and the second side, an electronic component, including at least one circuit, and disposed on at least some of the plurality of solder balls, and a resin, disposed along the first side, and filling a portion of a space disposed between the surface of the printed circuit board and the electronic component, and wherein the printed circuit board may include a blocking structure, disposed between the plurality of solder balls and the first side, and extending along the first side to separate at least some of the plurality of solder balls from the resin.

### [Advantageous Effects]

A semiconductor package and an electronic device according to an embodiment can provide a structure capable of increasing a life of an electronic component since at least some of the plurality of solder balls and a resin are spaced apart.

The effects that can be obtained from the present disclosure are not limited to those described above, and any other effects not mentioned herein will be clearly understood by those having ordinary knowledge in the art to which the present disclosure belongs, from the following description.

### [Description of the Drawings]

FIG. 1 is a block diagram of an electronic device in a network environment according to various embodiments.
FIG. 2 is a diagram illustrating an electronic device according to an embodiment.
FIG. 3 is an exploded perspective view of an electronic device according to an embodiment.
FIG. 4A is a perspective view of a semiconductor package according to an embodiment.
FIG. 4B is a top plan view of a printed circuit board of a semiconductor package according to an embodiment.
FIG. 5A is a cross-sectional view illustrating an example of a semiconductor package cut along line A-A of FIG. 4A according to an embodiment.
FIG. 5B is a cross-sectional view illustrating an example of a semiconductor package cut along line B-B of FIG. 4A according to an embodiment.
FIG. 6A is a top plan view of a printed circuit board of a semiconductor package according to an embodiment.
FIG. 6B is a cross-sectional view illustrating an example of a semiconductor package cut along line C-C' of FIG. 6A according to an embodiment.
FIG. 6C is a cross-sectional view illustrating an example of a semiconductor package cut along line D-D' of FIG. 6A according to an embodiment.

### [Mode for Invention]

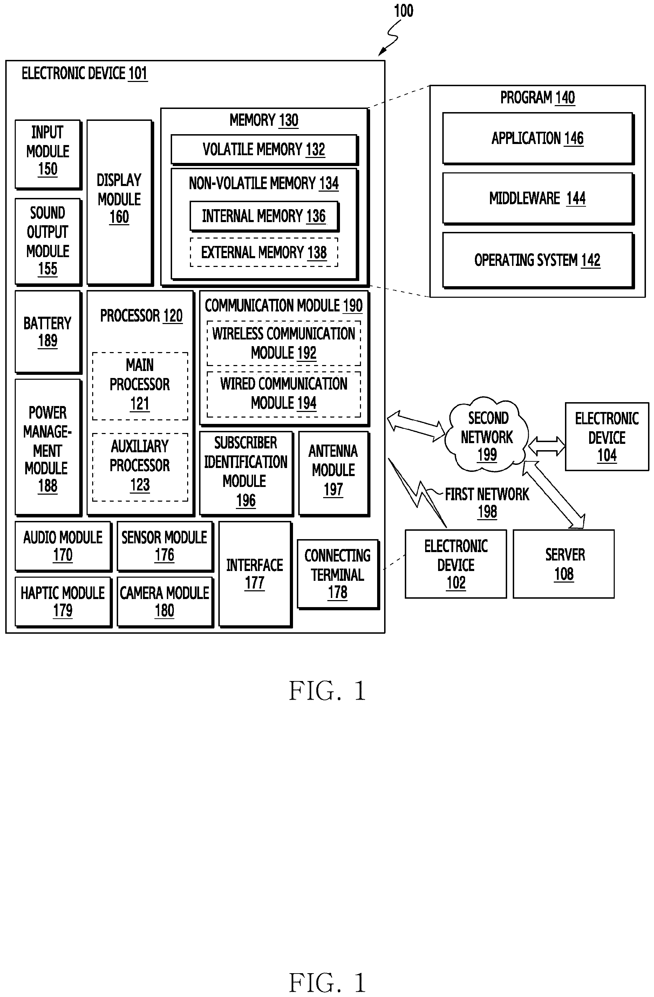

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

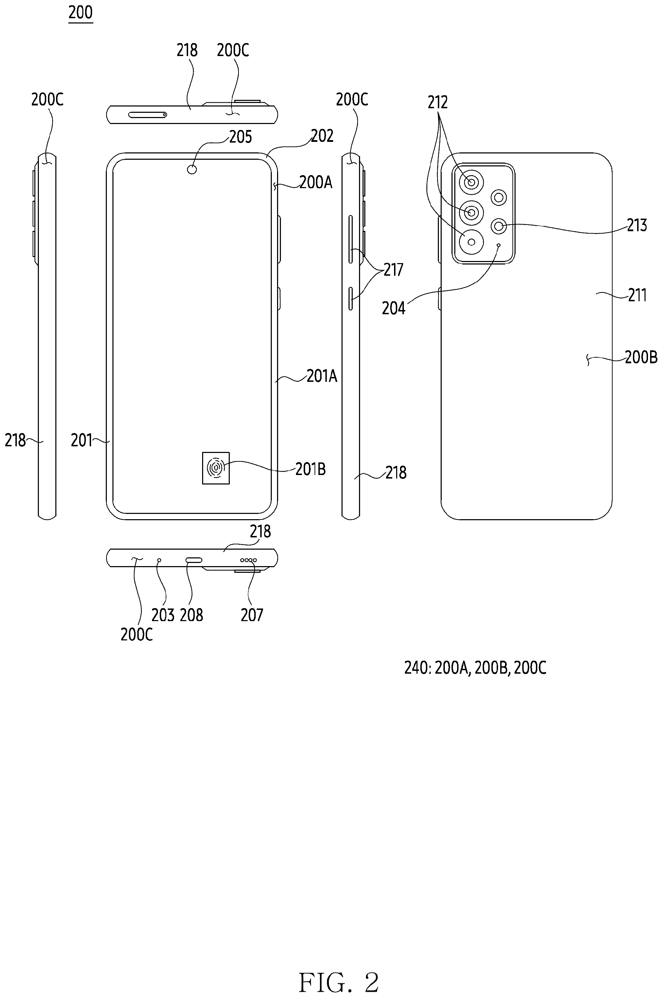

FIG. 2 is a diagram illustrating an electronic device according to an embodiment.

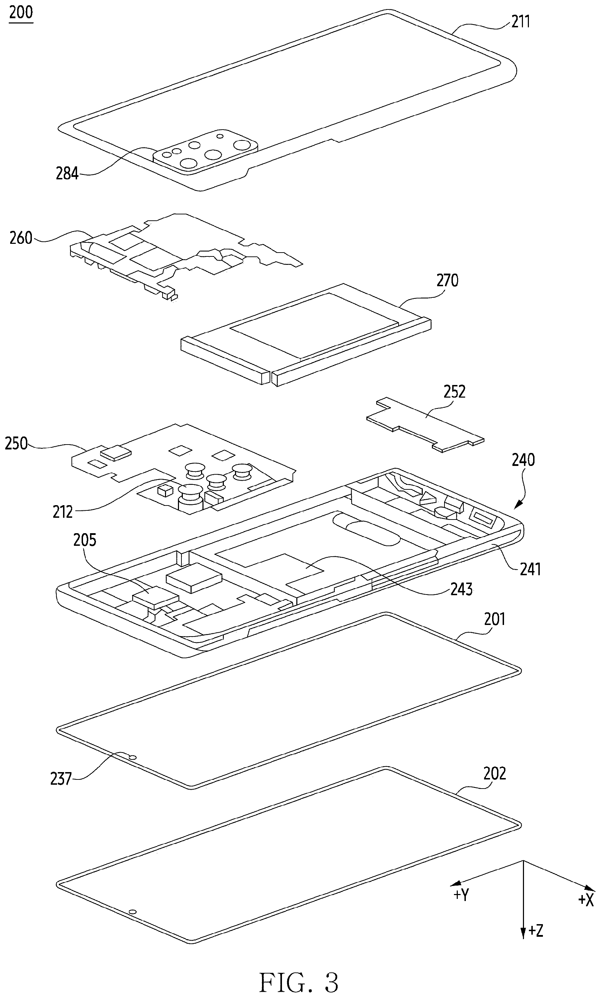

Referring to FIG. 2, an electronic device 200 according to an embodiment may include a housing that forms an exterior of the electronic device 200. For example, the housing may include a first surface (or a front surface) 200A, a second surface (or a rear surface) 200B, and a third surface (or a side surface) 200C surrounding a space between the first surface 200A and the second surface 200B. In an embodiment, the housing may refer to a structure (e.g., a frame structure 240 of FIG. 3) forming at least a portion of the first surface 200A, the second surface 200B, and/or the third surface 200C.

The electronic device 200 according to an embodiment may include a substantially transparent front plate 202. In an embodiment, the front plate 202 may form at least a portion of the first surface 200A. In an embodiment, the front plate 202 may include, for example, a glass plate or a polymer plate including various coating layers, but is not limited thereto.

The electronic device 200 according to an embodiment may include a substantially opaque rear plate 211. In an embodiment, the rear plate 211 may form at least a portion of the second surface 200B. In an embodiment, the rear plate 211 may be formed by coated or colored glass, a ceramic, a polymer, a metal (e.g., aluminum, stainless steel (STS), or magnesium), or a combination of at least two of the above materials.

The electronic device 200 according to an embodiment may include a side bezel structure (or a side member) 218 (e.g., a sidewall 241 of the frame structure 240 of FIG. 3). In an embodiment, the side bezel structure 218 may be coupled to the front plate 202 and/or the rear plate 211 to form at least a portion of the third surface 200C of the electronic device 200. For example, the side bezel structure 218 may form all of the third surface 200C of the electronic device 200, and for another example, the side bezel structure 218 may form the third surface 200C of the electronic device 200 together with the front plate 202 and/or the rear plate 211.

Unlike the illustrated embodiment, in case that the third surface 200C of the electronic device 200 is partially formed by the front plate 202 and/or the rear plate 211, the front plate 202 and/or the rear plate 211 may include a region that is bent toward the rear plate 211 and/or the front plate 202 from a periphery thereof and seamlessly extends. The extending region of the front plate 202 and/or the rear plate 211 may be located, for example, at both ends of a long edge of the electronic device 200, but it is not limited by the above-described example.

In an embodiment, the side bezel structure 218 may include a metal and/or a polymer. In an embodiment, the rear plate 211 and the side bezel structure 218 may be integrally formed and may include the same material (e.g., a metallic material such as aluminum), but is not limited thereto. For example, the rear plate 211 and the side bezel structure 218 may be formed in separate configuration and/or may include different materials.

In an embodiment, the electronic device 200 may include at least one of a display 201, audio modules 203, 204, and 207, a sensor module (not illustrated), camera modules 205, 212, and 213, a key input device 217, a light emitting element (not illustrated), and/or a connector hole 208. In another embodiment, the electronic device 200 may omit at least one (e.g., the key input device 217 or the light emitting element (not illustrated)) of the components or may additionally include another component.

In an embodiment, the display 201 (e.g., the display module 160 of FIG. 1) may be visually exposed through a significant portion of the front plate 202. For example, at least a portion of the display 201 may be seen through the front plate 202 forming the first surface 200A. In an embodiment, the display 201 may be disposed on a back surface of the front plate 202.

In an embodiment, an outer periphery shape of the display 201 may be formed substantially the same as an outer periphery shape of the front plate 202 adjacent to the display 201. In an embodiment, in order to expand an area in which the display 201 is visually exposed, a distance between an outer periphery of the display 201 and an outer periphery of the front plate 202 may be formed substantially the same.

In an embodiment, the display 201 (or the first surface 200A of the electronic device 200) may include a screen display region 201A. In an embodiment, the display 201 may provide visual information to a user through the screen display region 201A. In the illustrated embodiment, when the first surface 200A is viewed from the front, it is described that the screen display region 201A is spaced apart from an outer periphery of the first surface 200A and located inside the first surface 200A, but is not limited thereto. In another embodiment, when the first surface 200A is viewed from the front, at least a portion of the periphery of the screen display region 201A may substantially coincide with the periphery of the first surface 200A (or the front plate 202).

In an embodiment, the screen display region 201A may include a sensing region 201B configured to obtain user's biometric information. Herein, a meaning of "the screen display region 201A includes the sensing region 201B" may be understood to mean that at least a portion of the sensing region 201B may be overlapped with the screen display region 201A. For example, the sensing region 201B may mean a region capable of displaying visual information by the display 201, like other regions of the screen display region 201A, and additionally obtaining the user's biometric information (e.g., fingerprint). In another embodiment, the sensing region 201B may be formed in the key input device 217.

In an embodiment, the display 201 may include a region in which the first camera module 205 (e.g., the camera module 180 of FIG. 1) is located. In an embodiment, an opening may be formed in the region of the display 201, and the first camera module 205 (e.g., a punch hole camera) may be at least partially disposed in the opening to face the first surface 200A. In this case, the screen display region 201A may surround at least a portion of a periphery of the opening. In another embodiment, the first camera module 205 (e.g., an under display camera (UDC)) may be disposed under the display 201 to overlap the region of the display 201. In this case, the display 201 may provide visual information to the user through the region, and additionally, the first camera module 205 may obtain an image corresponding to a direction toward the first surface 200A through the region of the display 201.

In an embodiment, the display 201 may be coupled to or disposed adjacent to a touch sensing circuit, a pressure sensor capable of measuring intensity (pressure) of a touch, and/or a digitizer that detects a magnetic field type stylus pen.

In an embodiment, the audio modules 203, 204, and 207 (e.g., the audio module 170 of FIG. 1) may include microphone holes 203 and 204, and a speaker hole 207.

In an embodiment, the microphone holes 203 and 204 may include a first microphone hole 203 formed in a partial region of the third surface 200C and a second microphone hole 204 formed in a partial region of the second surface 200B. A microphone (not illustrated) for obtaining external sound may be disposed in the microphone holes 203 and 204. The microphone may include a plurality of microphones to sense a direction of the sound.

In an embodiment, the second microphone hole 204 formed in the partial region of the second surface 200B may be disposed adjacent to the camera modules 212 and 213. For example, the second microphone hole 204 may obtain a sound according to an operation of the camera modules 212 and 213. However, it is not limited thereto.

In an embodiment, the speaker hole 207 may include an external speaker hole 207 and a call receiver hole (not illustrated). The external speaker hole 207 may be formed in a portion of the third surface 200C of the electronic device 200. In another embodiment, the external speaker hole 207 may be implemented as one hole with the microphone hole 203. Although not illustrated, the call receiver hole (not illustrated) may be formed on another portion of the third surface 200C. For example, the call receiver hole may be formed on an opposite side of the external speaker hole 207 on the third surface 200C. For example, based on the illustration of FIG. 2, the external speaker hole 207 may be formed on the third surface 200C corresponding to a lower portion of the electronic device 200, and the call receiver hole may be formed on the third surface 200C corresponding to an upper portion of the electronic device 200. But it is not limited thereto, and in another embodiment, the call receiver hole may be formed at a position other than the third surface 200C. For example, the call receiver hole may be formed by a separated space between the front plate 202 (or, the display 201) and the side bezel structure 218.

In an embodiment, the electronic device 200 may include at least one speaker (not illustrated) configured to output sound to the outside of the housing through the external speaker hole 207 and/or the call receiver hole (not illustrated).

In an embodiment, the sensor module (not illustrated) (e.g., the sensor module 176 of FIG. 1) may generate an electrical signal or a data value corresponding to an internal operating state of the electronic device 200 or an external environmental state. For example, the sensor module may include at least one of a proximity sensor, an HRM sensor, a fingerprint sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera modules 205, 212, and 213 (e.g., the camera module 180 of FIG. 1) may include the first camera module 205 disposed to face the first surface 200A of the electronic device 200, the second camera module 212 disposed to face the second surface 200B, and the flash 213.

In an embodiment, the second camera module 212 may include a plurality of cameras (e.g., a dual camera, a triple camera, or a quad camera). However, the second camera module 212 is not necessarily limited to including a plurality of cameras, and may include one camera.

In an embodiment, the first camera module 205 and the second camera module 212 may include one or a plurality of lenses, an image sensor, and/or an image signal processor.

In an embodiment, the flash 213 may include, for example, a light emitting diode or a xenon lamp. In another embodiment, two or more lenses (an infrared camera, a wide-angle and telephoto lens) and image sensors may be disposed on a surface of the electronic device 200.

In an embodiment, the key input device 217 (e.g., the input module 150 of FIG. 1) may be disposed on the third surface 200C of the electronic device 200. In another embodiment, the electronic device 200 may not include some or all of the key input devices 217, and the excluded key input device 217 may be implemented in another form, such as a soft key, on the display 201.

In an embodiment, the connector hole 208 may be formed on the third surface 200C of the electronic device 200 to accommodate a connector of an external device. A connection terminal (e.g., the connection terminal 178 of FIG. 1) electrically connected to a connector of the external device may be disposed in the connector hole 208. The electronic device 200 according to an embodiment may include an interface module (e.g., the interface 177 of FIG. 1) for processing an electrical signal transmitted and received through the connection terminal.

According to an embodiment, the electronic device 200 may include the light emitting element (not illustrated). For example, the light emitting element (not illustrated) may be disposed on the first surface 200A of the housing. The light emitting element (not illustrated) may provide state information of the electronic device 200 in an optical form. In another embodiment, the light emitting element (not illustrated) may provide a light source in conjunction with an operation of the first camera module 205. For example, the light emitting element (not illustrated) may include an LED, an IR LED, and/or the xenon lamp.

FIG. 3 is an exploded perspective view of an electronic device according to an embodiment.

Hereinafter, an overlapping description of a configuration having the same reference numeral as the above-described configuration will be omitted.

Referring to FIG. 3, an electronic device 200 according to an embodiment may include a frame structure 240, a first printed circuit board 250, a second printed circuit board 252, a cover plate 260, and a battery 270.

In an embodiment, the frame structure 240 may include a sidewall 241 forming an exterior (e.g., the third surface 200C of FIG. 2) of the electronic device 200 and a supporting portion 243 extending inward from the sidewall 241. In an embodiment, the frame structure 240 may be disposed between a display 201 and a rear plate 211. In an embodiment, the sidewall 241 of the frame structure 240 may surround a space between the rear plate 211 and a front plate 202 (and/or the display 201), and the supporting portion 243 of the frame structure 240 may extend from the sidewall 241 within the space.

In an embodiment, the frame structure 240 may support or accommodate other components included in the electronic device 200. For example, the display 201 may be disposed on a surface of the frame structure 240 facing a direction (e.g., a +z direction), and the display 201 may be supported by the supporting portion 243 of the frame structure 240. For another example, the first printed circuit board 250, the second printed circuit board 252, the battery 270, and a second camera module 212 may be disposed on another surface of the frame structure 240 facing a direction (e.g., a -z direction) opposite to the direction. The first printed circuit board 250, the second printed circuit board 252, the battery 270, and the second camera module 212 may be respectively seated in a recess defined by the sidewall 241 and/or the supporting portion 243 of the frame structure 240.

In an embodiment, the first printed circuit board 250, the second printed circuit board 252, and the battery 270 may be coupled to the frame structure 240, respectively. For example, the first printed circuit board 250 and the second printed circuit board 252 may be fixedly disposed in the frame structure 240 through a coupling member such as a screw. For example, the battery 270 may be fixedly disposed in the frame structure 240 through an adhesive member (e.g., a double-sided tape), but it is not limited by the above-described example.

In an embodiment, the cover plate 260 may be disposed between the first printed circuit board 250 and the rear plate 211. In an embodiment, the cover plate 260 may be disposed on the first printed circuit board 250. For example, the cover plate 260 may be disposed on a surface facing the -z direction of the first printed circuit board 250.

In an embodiment, the cover plate 260 may at least partially overlap the first printed circuit board 250 with respect to the z-axis. In an embodiment, the cover plate 260 may cover at least a partial region of the first printed circuit board 250. Accordingly, the cover plate 260 may protect the first printed circuit board 250 from a physical impact or prevent detachment of a connector (not illustrated) coupled to the first printed circuit board 250.

In an embodiment, the cover plate 260 may be fixedly disposed on the first printed circuit board 250 through a coupling member (e.g., a screw), or may be coupled to the frame structure 240 together with the first printed circuit board 250 through the coupling member.

In an embodiment, the display 201 may be disposed between the frame structure 240 and the front plate 202. For example, the front plate 202 may be disposed on a side (e.g., +z direction) of the display 201, and the frame structure 240 may be disposed on another side (e.g., - z direction).

In an embodiment, the front plate 202 may be coupled to the display 201. For example, the front plate 202 and the display 201 may be adhered to each other through an optical adhesive member (e.g., an optically clear adhesive (OCA) or an optically clear resin (OCR)) interposed therebetween.

In an embodiment, the front plate 202 may be coupled to the frame structure 240. For example, the front plate 202 may include an outer periphery portion extending outside the display 201 when viewed in the z-axis direction, and may be attached to the frame structure 240 through the adhesive member (e.g., the double-sided tape) disposed between the outer periphery portion of the front plate 202 and the frame structure 240 (e.g., the sidewall 241). However, it is not limited by the above-described example.

In an embodiment, the first printed circuit board 250 and/or the second printed circuit board 252 may be equipped with a processor (e.g., the processor 120 of FIG. 1), a memory (e.g., the memory 130 of FIG. 1), and/or an interface (e.g., the interface 177 of FIG. 1). The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 200 to an external electronic device, and may include a USB connector, an SD card/MMC connector, or an audio connector. In an embodiment, the first printed circuit board 250 and the second printed circuit board 252 may be operatively or electrically connected to each other through a connection member (e.g., a flexible printed circuit board).

In an embodiment, the battery 270 (e.g., the battery 189 of FIG. 1) may supply power to at least one component of the electronic device 200. For example, the battery 270 may include a rechargeable secondary battery or a fuel cell. At least a portion of the battery 270 may be disposed on substantially a same plane as the first printed circuit board 250 and/or the second printed circuit board 252.

The electronic device 200 according to an embodiment may include an antenna module (not illustrated) (e.g., the antenna module 197 of FIG. 1). In an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power with the external device.

In an embodiment, a first camera module 205 (e.g., a front camera) may be disposed on at least a portion (e.g., the supporting portion 243) of the frame structure 240 so that a lens may receive external light through a partial region (e.g., the camera region 237) of the front plate 202 (e.g., the front surface 200A of FIG. 2).

In an embodiment, the second camera module 212 (e.g., a rear camera) may be disposed between the frame structure 240 and the rear plate 211. In an embodiment, the second camera module 212 may be electrically connected to the first printed circuit board 250 through a connection member (e.g., a connector). In an embodiment, the second camera module 212 may be disposed so that the lens may receive the external light through a camera region 284 of the rear plate 211 of the electronic device 200.

In an embodiment, the camera region 284 may be formed on a surface (e.g., the rear surface 200B of FIG. 2) of the rear plate 211. In an embodiment, the camera region 284 may be formed at least partially transparent so that external light may be incident to the lens of the second camera module 212. In an embodiment, at least a portion of the camera region 284 may protrude from the surface of the rear plate 211 by a predetermined height. However, it is not limited thereto, and in another embodiment, the camera region 284 may form substantially the same plane as the surface of the rear plate 211.

In an embodiment, a housing of the electronic device 200 may mean a configuration or a structure forming at least a portion of the exterior of the electronic device 200. In this regard, at least a portion of the front plate 202, the frame structure 240, and/or the rear plate 211 forming the exterior of the electronic device 200 may be referred to as the housing of the electronic device 200.

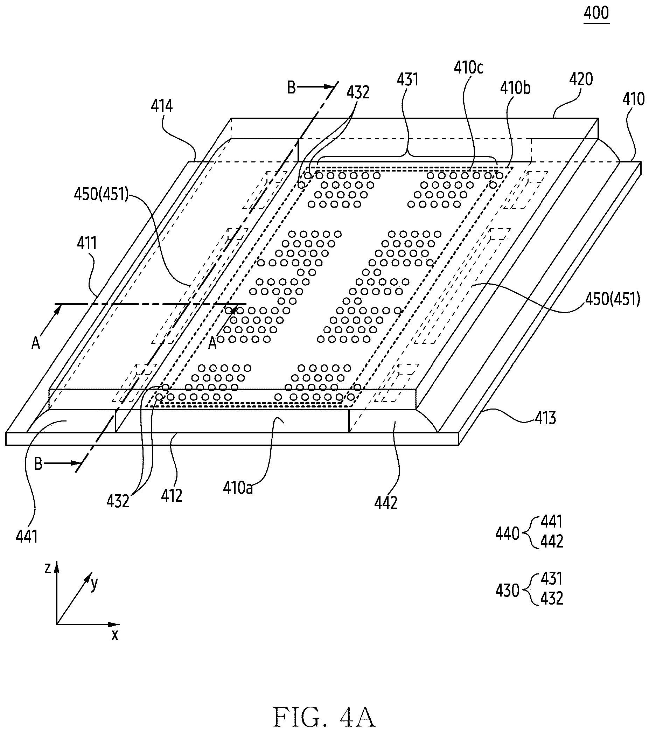

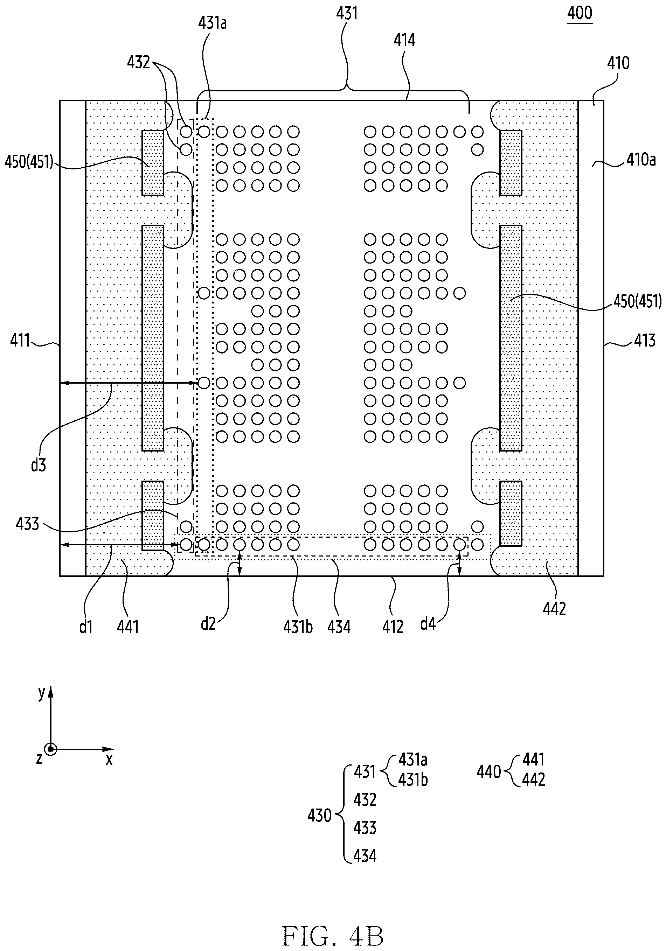

FIG. 4A is a perspective view of a semiconductor package according to an embodiment, and FIG. 4B is a top plan view of a printed circuit board of the semiconductor package according to an embodiment.

Referring to FIGS. 4A and 4B, a semiconductor package 400 according to an embodiment may include a printed circuit board 410, an electronic component 420, a plurality of solder balls 430, a resin 440, and/or a blocking structure 450. The semiconductor package 400 may be disposed in an electronic device (e.g., the electronic device 200 of FIG. 2). For example, the semiconductor package 400 may be disposed on a first printed circuit board (e.g., the first printed circuit board 250 of FIG. 3) in the electronic device 200. For another example, the semiconductor package 400 may define at least a portion of the first printed circuit board 250.

The printed circuit board 410 may form an electrical connection between components of the semiconductor package 400. According to an embodiment, the printed circuit board 410 may support the components of the semiconductor package 400. According to an embodiment, the printed circuit board 410 may include a first side 411, a second side 412, a third side 413, and/or a fourth side 414. The first side 411, the second side 412, the third side 413, and/or the fourth side 414 may define a boundary of the printed circuit board 410. The first side 411 may extend in a first direction (e.g., +y direction). The second side 412 may be substantially perpendicular to the first side 411. The second side 412 may extend from an end of the first side 411 in a second direction (e.g., +x direction) substantially perpendicular to the first direction. The third side 413 may be connected to the second side 412 substantially perpendicularly. For example, the third side 413 may be connected to an end of the second side 412 facing the second direction. The third side 413 may be substantially parallel to the first side 411. The third side 413 may face away from the first side 411 and may be spaced apart from the first side 411 in the second direction. The fourth side 414 may extend from another end of the first side 411 facing the first direction to an end of the third side 413 facing the first direction. The fourth side 414 may be substantially perpendicular to the first side 411 and the third side 413. The fourth side 414 may be substantially parallel to the second side 412. For example, the fourth side 414 may face away from the second side 412 and may be spaced apart from the second side 412 in the first direction. According to an embodiment, a length of the first side 411 may be substantially the same as a length of the third side 413. A length of the second side 412 may be substantially the same as a length of the fourth side 141. According to an embodiment, a length of each of the first side 411 and the third side 413 may be longer than a length of each of the second side 412 and the fourth side 414.

The electronic component 420 may include at least one circuit for implementing various functions of the electronic device 200. According to an embodiment, the electronic component 420 may be disposed on a surface 410a of the printed circuit board 410. For example, the electronic component 420 may be spaced apart from the surface 410a of the printed circuit board 410 in a direction (e.g., +z direction) toward which the surface 410a of the printed circuit board 410 faces. According to an embodiment, the electronic component 420 may include a plurality of chips stacked in the direction toward which the surface 410a of the printed circuit board 410 faces. For example, the plurality of chips may include a memory device for recording data required for an operation of a processor (e.g., the processor 120 of FIG. 1). The memory device may include, for example, at least one from among a static random access memory (SRAM), a dynamic random access memory (DRAM), a resistive random access memory (RRAM), a utilized random access memory (utilized RAM), a Ferro-electric random access memory (Ferro-electric RAM), a fast cycle random access memory (fast cycle RAM), a phase changeable random access memory (phase changeable RAM), a magnetic random access memory (magnetic RAM), a NAND flash, but is not limited thereto. According to an embodiment, the plurality of chips may be electrically connected to each other through a through silicon via. The electronic component 420 may be referred to as, for example, a multi-chip package (MCP).

The plurality of solder balls 430 may electrically connect the printed circuit board 410 and the electronic component 420. According to an embodiment, the plurality of solder balls 430 may be disposed on the surface 410a of the printed circuit board 410. For example, the plurality of solder balls 430 may be interposed between the printed circuit board 410 and the electronic component 420. According to an embodiment, each of the plurality of solder balls 430 may be disposed on the surface 410a of the printed circuit board 410 by a reflow process. For example, each of the plurality of solder balls 430 may include at least one from among lead (Pb), tin (Sn), silver (Ag), copper (Cu), aluminum (Al), and an alloy of lead (Pb) and tin (Sn). According to an embodiment, the plurality of solder balls 430 may be spaced apart from the first side 411 and the second side 412. For example, the plurality of solder balls 430 may be surrounded by the first side 411, the second side 412, the third side 413, and the fourth side 414.

According to an embodiment, the electronic component 420 may be disposed on at least some of the plurality of solder balls 430. For example, the plurality of solder balls 430 may include a plurality of signal solder balls 431 and at least one dummy solder ball 432. Each of the plurality of signal solder balls 431 may electrically connect the electronic component 420 to the printed circuit board 410. The at least one dummy solder ball 432 may be electrically disconnected from the electronic component 420. According to an embodiment, the at least one dummy solder ball 432 may be disposed at a periphery of a first region 410b of the printed circuit board 410 in which the plurality of solder balls 430 is disposed. For example, the at least one dummy solder ball 432 may surround the plurality of signal solder balls 431. For another example, the at least one dummy solder ball 432 may be disposed outside a second region 410c of the printed circuit board 410 in which the plurality of signal solder balls 431 are disposed. The second region 410c may mean a portion of the first region 410b in which the plurality of signal solder balls 431 is disposed, among the first region 410b of the printed circuit board 410 in which the plurality of solder balls 430 is disposed. In other words, the second region 410c may be included in the first region 410b. According to an embodiment, the at least one dummy solder ball 432 may overlap with the electronic component 420 when the printed circuit board 410 is viewed from above (e.g., -z direction or +z direction), but is not limited thereto. According to embodiments, the at least one dummy solder ball 432 may be spaced apart from the electronic component 420 without overlapping the electronic component 420, when the printed circuit board 410 is viewed from above.

According to an embodiment, the number of the solder balls 430 spaced apart from the first side 411 by a shortest distance among the plurality of solder balls 430 may be smaller than the number of solder balls spaced apart from the second side 412 by a shortest distance among the plurality of solder balls. According to an embodiment, each of the plurality of solder balls 430 may be spaced apart from the first side 411 in the second direction (e.g., +x direction). A portion (or a set) of the plurality of solder balls 430 may be closer to the first side 411 than a remaining portion of the plurality of solder balls 430. For example, a first distance d1 between a potion (or a set) 433 of the plurality of solder balls 430 and the first side 411 may be shorter than a distance between the remaining portion of the plurality of solder balls 430 and the first side 411. The first distance d1 may be parallel to the second direction. According to an embodiment, each of the plurality of solder balls 430 may be spaced apart from the second side 412 in the first direction (e.g., +y direction). Another portion (or another set) 434 of the plurality of solder balls 430 may be closer to the second side 412 than to the remaining portion of the plurality of solder balls 430. For example, a second distance d2 between the other portion 434 of the plurality of solder balls 430 and the second side 412 may be shorter than a distance between the remaining portion of the plurality of solder balls 430 and the second side 412. The second distance d2 may be parallel to the first direction. According to an embodiment, the number of the portion 433 of the plurality of solder balls 430 may be smaller than the number of the other portion 434 of the plurality of solder balls 430. The portion 433 of the plurality of solder balls 430 may include only the dummy solder ball 432.

According to an embodiment, among the plurality of solder balls 430, a shortest distance between the plurality of signal solder balls 431 electrically connected to the electronic component 420 and the second side 412 may be shorter than a shortest distance between the plurality of signal solder balls 431 and the first side 411. Each of the plurality of signal solder balls 431 may be spaced apart from the first side 411 in the second direction (e.g., +x direction). A portion (or a set) 431a of the plurality of signal solder balls 431 may be closer to the first side 411 than a remaining portion of the plurality of signal solder balls 431. For example, a third distance d3 between a portion 431a of the plurality of signal solder balls 431 and the first side 411 may be shorter than a distance between the remaining portion of the plurality of signal solder balls 431 and the first side 411. The third distance d3 may be parallel to the second direction. Each of the plurality of signal solder balls 431 may be spaced apart from the second side 412 in the first direction. Another portion (or another set) 431b of the plurality of signal solder balls 431 may be closer to the second side 412 than to a remaining portion of the plurality of signal solder balls 431. The other portion 431b of the plurality of signal solder balls 431 may mean the plurality of solder balls 430 in which at least one dummy solder ball 432 is excluded from the other portion 434 of the plurality of solder balls 430. For example, a fourth distance d4 between the other portion 431b of the plurality of signal solder balls 431 and the second side 412 may be shorter than a distance between a remaining portion of the plurality of signal solder balls 431 parallel to the first direction and the second side 412. The fourth distance d4 may be parallel to the first direction. According to an embodiment, the fourth distance d4 may be shorter than the third distance d3.

The resin 440 may protect the printed circuit board 410 and the electronic component 420 from an impact transmitted from the outside of the semiconductor package 400. According to an embodiment, the resin 440 may be disposed between the printed circuit board 410 and the electronic component 420. For example, the resin 440 may fill a portion of a space disposed between the surface 410a of the printed circuit board 410 and the electronic component 420. For example, the resin 440 may include an epoxy resin. According to an embodiment, the resin 440 may be referred to as an underfill resin. For example, the resin 440 may be disposed on the printed circuit board 410 by a capillary underfill (CUF) method. When manufacturing the semiconductor package 400, the resin 440 may be disposed on the printed circuit board 410 to be adjacent to the electronic component 420 in a molten state. The molten resin 440 may be introduced into a space between the electronic component 420 and the printed circuit board 410 through a capillary phenomenon. The resin introduced into the space between the electronic component 420 and the printed circuit board 410 may be cooled and fill a portion of the space disposed between the electronic component 420 and the surface 410a of the printed circuit board 410.

According to an embodiment, the resin 440 may be disposed along the first side 411 and the third side 413 to minimize the number of solder balls in contact with the resin 440. For example, when manufacturing the semiconductor package 400, the resin 440 may be introduced based on the first side 411 and the third side 413. According to an embodiment, the resin 440 may include a first cover region 441 disposed along the first side 411, and a second cover region 442 disposed along the third side 413. The first cover region 441 may be spaced apart from the first side 411 and may extend in the first direction substantially parallel to the first side 411. The second cover region 442 may be spaced apart from the first cover region 441. For example, the second cover region 442 may be spaced apart from the first cover region 441 in the second direction. The second cover region 442 may be spaced apart from the third side 413 and may extend in the first direction substantially parallel to the third side 413. For example, when manufacturing the semiconductor package 400, in case that the resin 440 is introduced based on the second side 412, since the number of solder balls close to the second side 412 is greater than the number of solder balls close to the first side 411, the number of solder balls in contact with the resin 440 may increase. As the number of solder balls in contact with the resin 440 increases, a possibility that a life of the semiconductor package 400 decreases may increase. For example, since a thermal expansion coefficient of the resin 440 is different from a thermal expansion coefficient of the plurality of solder balls 430, as the number of solder balls in contact with the resin 440 increases, damage to the plurality of solder balls 430 may occur due to thermal expansion or thermal contraction of the resin 440. The semiconductor package 400 according to an embodiment may provide a structure capable of increasing a life of the semiconductor package 400 by the resin 440 disposed along the first side 411 and the third side 413.

According to an embodiment, a ratio of an area of a portion of the surface 410a of the printed circuit board 410 in contact with the resin 440 to an area of the surface 410a of the printed circuit board 410 may be approximately 20% to 40%. For example, the ratio of the area of a portion of the surface 410a of the printed circuit board 410 in contact with the resin 440 to the area of the surface 410a of the printed circuit board 410 may be approximately 30%. For example, in case that an amount of the resin 440 disposed on the printed circuit board 410 is excessively small, the semiconductor package 400 may be vulnerable to a physical impact transmitted from the outside of the semiconductor package 400. In case that the amount of the resin 440 disposed on the printed circuit board 410 is excessively large, the semiconductor package 400 may be vulnerable to thermal stress. The semiconductor package 400 according to an embodiment may provide a structure robust to a physical impact and/or thermal stress by including an appropriate amount of resin 440.

The blocking structure 450 may delay movement of the molten resin 440 when manufacturing the semiconductor package 400. For example, when manufacturing the semiconductor package 400, the blocking structure 450 may delay inflow of the molten resin 440 disposed along the first side 411 in the second direction. For another example, when manufacturing the semiconductor package 400, the blocking structure 450 may delay inflow of the molten resin 440 disposed along the third side 413 in a direction (e.g., -x direction) opposite to the second direction. According to an embodiment, the blocking structure 450 may be disposed between the plurality of solder balls 430 and the first side 411. The blocking structure 450 may be disposed between the plurality of solder balls 430 and the third side 413. For example, the blocking structure 450 may be spaced apart from the first side 411 in the second direction. For another example, the blocking structure 450 may be spaced apart from the third side 413 in a direction (e.g., -x direction) opposite to the second direction. For example, in case that the blocking structure 450 is not disposed, the resin 440 and a portion of the plurality of signal solder balls 431 may be contact with each other, by movement of the molten resin 440 disposed along the first side 411. In case that the resin 440 and a portion of the plurality of signal solder balls 431 are in contact with each other, damage to a portion of the plurality of signal solder balls 431 may occur due to a difference in a thermal expansion coefficient between the resin 440 and the plurality of signal solder balls 431. As the damage to the portion of the plurality of signal solder balls 431 may occur, the electronic component 420 may not perform a pre-designed function. In case that the blocking structure 450 is disposed between the first side 411 and the plurality of solder balls 430, as movement of the molten resin 440 is delayed by the blocking structure 450, the molten resin 440 may be cooled before contacting the plurality of signal solder balls 431. As the molten resin 440 is cooled before contacting the plurality of signal solder balls 431, damage to the plurality of signal solder balls 431 by thermal deformation of the resin 440 may be prevented.

According to an embodiment, the blocking structure 450 may separate the at least a portion of the plurality of solder balls 430 from the resin 440. For example, by the blocking structure 450, the resin 440 may be spaced apart from the plurality of signal solder balls 431 and may be contacted to at least one dummy solder ball 432, but is not limited thereto. According to embodiments, the resin 440 may be spaced apart from all of the plurality of solder balls 430 by the blocking structure 450. According to an embodiment, the blocking structure 450 may overlap the electronic component 420 when the printed circuit board 410 is viewed from above (e.g., -z direction or +z direction), but is not limited thereto. According to embodiments, the blocking structure 450 may be spaced apart from the electronic component 420 when the printed circuit board 410 is viewed from above. For example, the blocking structure 450 may be spaced apart from the electronic component 420 in a direction (e.g., -x direction) toward the first side 411, when the printed circuit board 410 is viewed from above. For example, when the printed circuit board 410 is viewed from above, the blocking structure 450 may be spaced apart from the electronic component 420 in a direction (e.g., +x direction) toward the third side 413. According to an embodiment, the blocking structure 450 may extend along the first side 411. The blocking structure 450 may extend along the third side 413. For example, the blocking structure 450 may have a shape extending in the first direction (e.g., +y direction) along the first side 411. For another example, the blocking structure 450 may have a shape extending in the first direction along the third side 413.

According to an embodiment, the blocking structure 450 may include at least one blocking groove 451. The at least one blocking groove 451 may be formed by recessing the surface 410a of the printed circuit board 410 inward. For example, the at least one blocking groove 451 may be formed by recessing a portion of the printed circuit board 410 in a direction (e.g., -z direction) from the electronic component 420 toward the printed circuit board 410. When manufacturing the semiconductor package 400, the molten resin 440 may be accommodated in the at least one blocking groove 451. As the molten resin 440 is accommodated in the at least one blocking groove 451, movement of the resin 440 in an amount corresponding to a volume of the at least one blocking groove 451 may be delayed. As movement of the molten resin 440 is delayed, the molten resin 440 may be cooled in the at least one blocking groove 451. According to an embodiment, the at least one blocking groove 451 may be formed by removing a portion of the plurality of layers included in the printed circuit board 410. For example, the at least one blocking groove 451 may be formed by removing a portion of the plurality of conductive layers and a portion of the plurality of non-conductive layers included in the printed circuit board 410. For example, as a portion of the plurality of layers included in the printed circuit board 410 is removed, a portion of the plurality of non-conductive layers may be exposed to the outside of the printed circuit board 410 through the at least one blocking groove 451. For example, as a portion of the plurality of layers included in the printed circuit board 410 is removed, a portion of the plurality of conductive layers may be exposed to the outside of the printed circuit board 410 through the at least one blocking groove 451.

As described above, the semiconductor package 400 according to an embodiment may provide a structure capable of increasing a life of the semiconductor package 400 by the blocking structure 450 disposed between the first side 411 and/or the third side 413 and the plurality of solder balls 430.

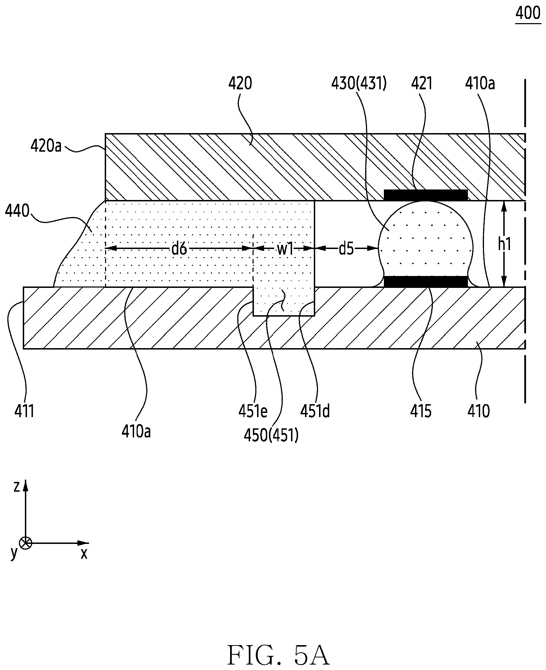

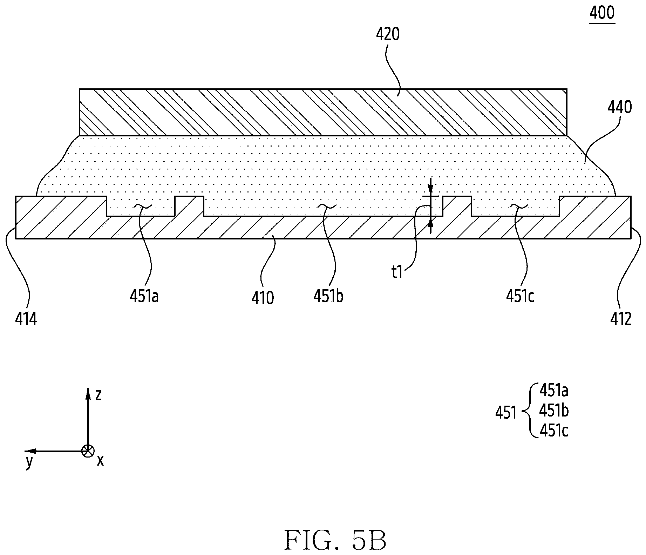

FIG. 5A is a cross-sectional view illustrating an example of a semiconductor package cut along line A-A of FIG. 4A, and FIG. 5B is a cross-sectional view illustrating an example of a semiconductor package cut along line B-B of FIG. 4A.

Referring to FIGS. 5A and 5B, according to an embodiment, a printed circuit board 410 may include at least one first conductive pad 415. The at least one first conductive pad 415 may be disposed on a surface 410a of the printed circuit board 410 and may be contacted with at least some of a plurality of solder balls 430. For example, the at least one first conductive pad 415 may protrude from the surface 410a of the printed circuit board 410 in a direction (e.g., +z direction) in which the surface 410a of the printed circuit board 410 faces. According to an embodiment, the number of the at least one first conductive pad 415 may correspond to the number of the plurality of solder balls 430. For example, the number of the at least one first conductive pad 415 may be equal to a sum of the number of a plurality of signal solder balls 431 and the number of at least one dummy solder ball (e.g., at least one dummy solder ball 432 of FIGS. 4A and 4B). The at least one first conductive pad 415 may be electrically connected to a signal line (not illustrated) disposed inside the printed circuit board 410.

According to an embodiment, an electronic component 420 may include at least one second conductive pad 421. The at least one second conductive pad 421 may face the surface 410a of the printed circuit board 410. The at least one second conductive pad 421 may be contacted with at least some of the plurality of solder balls 430. For example, the at least one second conductive pad 421 may be contacted with the plurality of signal solder balls 431. The at least one second conductive pad 421 may be spaced apart from the at least one dummy solder ball 432. According to an embodiment, the at least some of the plurality of solder balls 430 may electrically connect the printed circuit board 410 and the electronic component 420 by contacting to the at least one first conductive pad 415 and the at least one second conductive pad 421.

According to an embodiment, at least one blocking groove 451 may include a plurality of blocking grooves 451a, 451b, and 451c spaced apart from each other along a first direction (e.g., +y direction) substantially parallel to a first side 411. For example, each of the plurality of blocking grooves 451a, 451b, and 451c may be disposed between a second side 412 and a fourth side 414 and spaced apart from each other. According to an embodiment, a signal line (not illustrated) electrically connected to the electronic component 420 may be disposed between the plurality of blocking grooves 451a, 451b, and 451c. Through a signal line, the electronic component 420 may receive data or power from the outside of a semiconductor package 400, or transmit data or power to the outside of the semiconductor package 400.

According to an embodiment, a height h1 of each of the plurality of solder balls 430 may be approximately 0.1 mm to 0.16 mm. The height h1 of each of the plurality of solder balls 430 may mean a length in the direction (e.g., +z direction) in which the surface 410a of the printed circuit board 410 faces.

According to an embodiment, a depth t1 of the at least one blocking groove 451 may be 0.05 mm. The depth t1 of the at least one blocking groove 451 may mean a length in a direction (e.g., -z direction) from the electronic component 420 toward the printed circuit board 410.

According to an embodiment, each of the plurality of signal solder balls 431 may be spaced apart from the at least one blocking groove 451. For example, a fifth distance d5 between each of the plurality of signal solder balls 431 and a first side surface 451d of the at least one blocking groove 451 may be less than or equal to five times the height h1 of each of the plurality of signal solder balls 431. The first side surface 451d of the at least one blocking groove 451 may mean a side surface close to the plurality of signal solder balls 431 among side surfaces 451d and 451e of the at least one blocking groove 451 perpendicular to a second direction (e.g., +x direction). For another example, the fifth distance d5 may be approximately 0.5 mm or less, but is not limited thereto.

According to an embodiment, a width w1 of the at least one blocking groove 451 may be greater than or equal to twice a height of each of the plurality of signal solder balls 431. The width w1 of the at least one blocking groove 451 may mean a distance between the first side surface 451d of the at least one blocking groove 451 and a second side surface 451e facing the first side surface 451d. The second side surface 451e may be spaced apart from the first side surface 451d in a direction (e.g., -x direction) opposite to the second direction. The second side surface 451e may mean a side surface close to the first side 411 among the side surfaces 451d and 451e of the at least one blocking groove 451 perpendicular to the second direction (e.g., +x direction). For example, the width w1 of the at least one blocking groove 451 may be approximately 0.2 mm or more, but is not limited thereto.

According to an embodiment, a sixth distance d6 between an exterior side surface 420a of the electronic component 420 and the at least one blocking groove 451 may be less than or equal to 10 times the height h1 of each of the plurality of signal solder balls 431. The exterior side surface 420a of the electronic component 420 may mean a surface of the electronic component 420, which is substantially perpendicular to the second direction (e.g., +x direction) and faces the first side 411. For example, the sixth distance d6 between the second side surface 451e of the at least one blocking groove 451 and the exterior side surface 420a of the electronic component 420 may be approximately 1 mm or less, but is not limited thereto.

According to an embodiment, a ratio of an area of the surface 410a of the printed circuit board 410, which is in contact with a resin 440 between the first side 411 and the plurality of solder balls 430, to an area of the surface 410a of the printed circuit board 410 may be approximately 15%. Although not illustrated in FIG. 5A, a ratio of an area of the surface 410a of the printed circuit board 410, which is in contact with the resin 440 between a third side (e.g., the third side 413 of FIG. 4A and FIG. 4B) and the plurality of solder balls 430, to the area of the surface 410a of the printed circuit board 410 may may be approximately 15%.

As described above, the semiconductor package 400 according to an embodiment may provide a structure robust to thermal stress and/or a physical impact by the at least one blocking groove 451 separating at least a portion of the plurality of signal solder balls 431 from the resin 440.

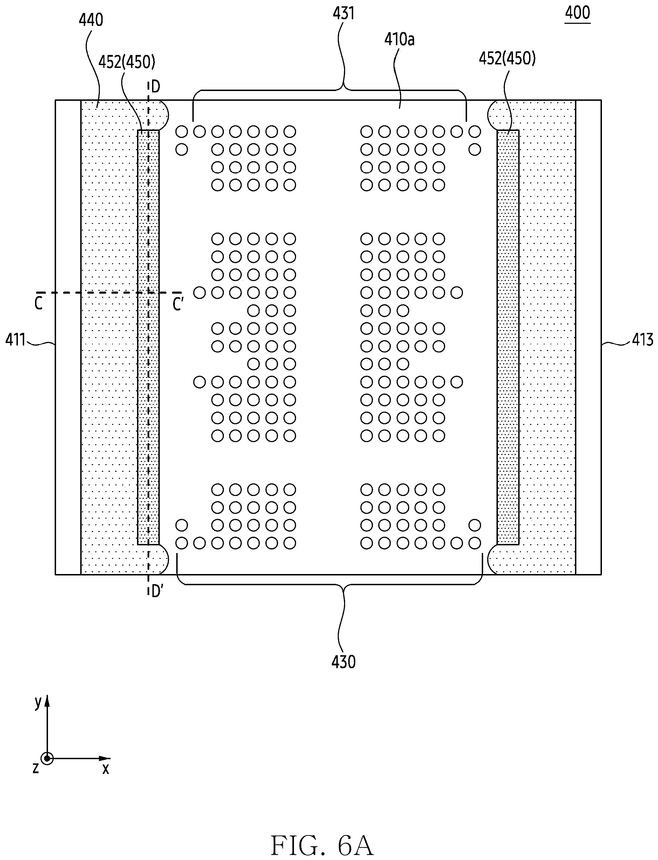

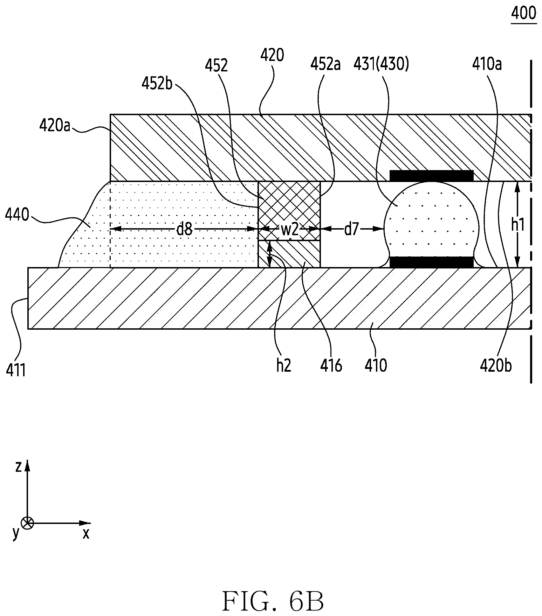

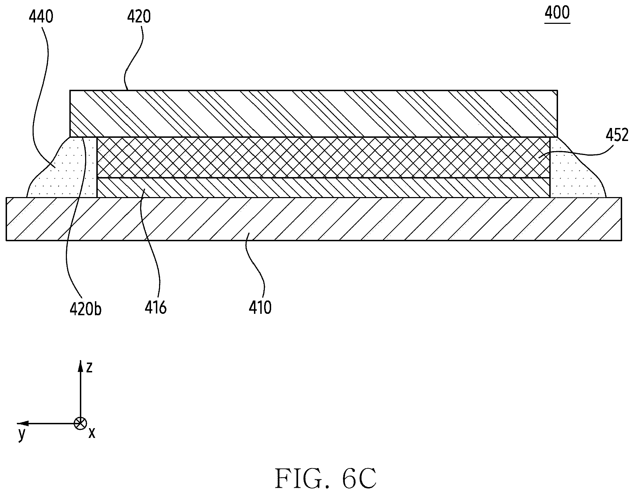

FIG. 6A is a top plan view of a printed circuit board of a semiconductor package according to an embodiment, FIG. 6B is a cross-sectional view illustrating an example of a semiconductor package cut along line C-C' of FIG. 6A, and FIG. 6C is a cross-sectional view illustrating an example of a semiconductor package cut along line D-D' of FIG. 6A according to an embodiment.

Referring to FIGS. 6A, 6B, and 6C, according to an embodiment, a blocking structure 450 may include at least one blocking partition wall 452. The at least one blocking partition wall 452 may protrude from a surface 410a of the printed circuit board 410. For example, the at least one blocking partition wall 452 may protrude from the surface 410a of the printed circuit board 410 along a direction (e.g., +z direction) in which the surface 410a of the printed circuit board 410 faces. According to an embodiment, the at least one blocking partition wall 452 may extend along a first side 411. For example, the at least one blocking partition wall 452 may extend in a first direction (e.g., +y direction) between the first side 411 and a plurality of solder balls 430. According to an embodiment, the at least one blocking partition wall 452 may extend along a third side 413. For example, the at least one blocking partition wall 452 may extend in the first direction (e.g., +y direction) between the third side 413 and the plurality of solder balls 430. When manufacturing the semiconductor package 400, the at least one blocking partition wall 452 may prevent movement of the molten resin 440 disposed along the first side 411 in a second direction (e.g., +x direction). As the movement is prevented by the at least one blocking partition wall 452, the molten resin 440 may be cooled by being spaced apart from at least some of the plurality of solder balls 430.

According to an embodiment, the printed circuit board 410 may include a supporting pad 416 disposed between the first side 411 and the plurality of solder balls 430. The supporting pad 416 may be disposed on the surface 410a of the printed circuit board 410. According to an embodiment, the at least one blocking partition wall 452 may be disposed on the supporting pad 416. For example, the at least one blocking partition wall 452 may be disposed on a surface of the supporting pad 416 facing an electronic component 420. According to an embodiment, the at least one blocking partition wall 452 may be disposed on the supporting pad 416 by a reflow process. For example, the at least one blocking partition wall 452 may include at least one of lead (Pb), tin (Sn), silver (Ag), copper (Cu), aluminum (Al), and an alloy of lead (Pb) and tin (Sn). However, it is not limited thereto, and the supporting pad 416 may be omitted according to embodiments. In case that the supporting pad 416 is omitted, the at least one blocking partition wall 452 may be in contact with the surface 410a of the printed circuit board 410.

According to an embodiment, the at least one blocking partition wall 452 may be contacted with the electronic component 420. For example, the at least one blocking partition wall 452 may be contacted with a surface 420b of the electronic component 420 facing the surface 410a of the printed circuit board 410.

According to an embodiment, a height h2 of the supporting pad 416 may be less than a height h1 of a plurality of solder balls 430. For example, the height h2 of the supporting pad 416 may be approximately 0.02 mm, but is not limited thereto.

According to an embodiment, each of a plurality of signal solder balls 431 may be spaced apart from the at least one blocking partition wall 452. For example, a seventh distance d7 between each of the plurality of signal solder balls 431 and a first side surface 452a of the at least one blocking partition wall 452 may be less than or equal to 5 times the height h1 of each of the plurality of signal solder balls 431. The first side surface 452a of the at least one blocking partition wall 452 may mean a side surface close to the plurality of signal solder balls 431 among side surfaces 452a and 452b of the at least one blocking partition wall 452 substantially perpendicular to the second direction (e.g., +x direction). For another example, the seventh distance d7 may be approximately 0.5 mm or less, but is not limited thereto.

According to an embodiment, a width w2 of the at least one blocking partition wall 452 may be greater than or equal to twice the height h1 of each of the plurality of signal solder balls 431. The width w2 of the at least one blocking partition wall 452 may mean a distance between the first side surface 452a of the at least one blocking partition wall 452 and the second side surface 452b facing the first side surface 452a. The second side surface 452b may be spaced apart from the first side surface 452a in a direction (e.g., -x direction) opposite to the second direction. A second side surface 452b may mean a side surface close to the first side 411 among the side surfaces 452a and 452b of the at least one blocking partition wall 452 substantially perpendicular to the second direction (e.g., +x direction). For example, the width w2 of the at least one blocking partition wall 452 may be approximately 0.2 mm or more, but is not limited thereto.

According to an embodiment, an eighth distance d8 between an exterior side surface 420a of the electronic component 420 and the at least one blocking partition wall 452 may be less than or equal to 10 times the height h1 of each of the plurality of signal solder balls 431. For example, the eighth distance d8 between the second side surface 452b of the at least one blocking partition wall 452 and the exterior side surface 420a of the electronic component 420 may be approximately 1 mm or less, but is not limited thereto.

According to an embodiment, a ratio of an area of the surface 410a of the printed circuit board 410, which is in contact with a resin 440 between the first side 411 and the plurality of solder balls 430, to an area of the surface 410a of the printed circuit board 410 may be approximately 15%. Although not illustrated in FIG. 6B, a ratio of an area of the surface 410a of the printed circuit board 410, which is in contact with the resin 440 between the third side (e.g., the third side 413 of FIG. 6A) and the plurality of solder balls 430, to the area of the surface 410a of the printed circuit board 410 may be approximately 15%.

As described above, the semiconductor package 400 according to an embodiment may provide a structure robust to thermal stress and/or a physical impact by the at least one blocking partition wall 452 separating at least a portion of the plurality of solder balls 430 from the resin 440.

Meanwhile, in FIGS. 6A, 6B, and 6C, it is illustrated that one partition wall is disposed along the first side 411, and one partition wall is disposed along the third side 413, but embodiments are not limited thereto. For example, the at least one blocking partition wall 452 may include a plurality of blocking partition walls extending along the first side 411 and spaced apart from each other. For example, the at least one blocking partition wall 452 may include a plurality of blocking partition walls extending along the third side 413 and spaced apart from each other.

According to an embodiment, an electronic device (e.g., the electronic device 200 of FIG. 2) may comprise a printed circuit board (e.g., the printed circuit board 410 of FIGS. 4A and 4B) including a first side (e.g., the first side 411 of FIGS 4A and 4B), and a second side (e.g., the second side 412 of FIGS. 4A and 4B) perpendicular to the first side, a plurality of solder balls (e.g., the solder balls 430 of FIGS. 4A and FIG. 4B), disposed on a surface (e.g., the surface 410a of FIGS. 4A and 4B) of the printed circuit board, and spaced apart from the first side and the second side, an electronic component (e.g., the electronic component 420 of FIGS. 4A and 4B), including at least one circuit, and disposed on at least some of the plurality of solder balls, and a resin (e.g., the resin 440 of FIGS. 4A and 4B), disposed along the first side, and filling a portion of a space defined between the surface of the printed circuit board and the electronic component, and wherein the printed circuit board may include a blocking structure (e.g., the blocking structure 450 of FIGS. 4A and 4B), disposed between the plurality of solder balls and the first side, and extending along the first side to separate the at least some of the plurality of solder balls from the resin.

According to an embodiment, the number of solder balls spaced apart from the first side by a shortest distance from among the plurality of solder balls may be smaller than the number of solder balls spaced apart from the second side by a shortest distance from among the plurality of solder balls.

According to an embodiment, a shortest distance (e.g., the fourth distance d4 of FIG. 4B) between a plurality of signal solder balls (e.g., the plurality of signal solder balls 431 of FIGS. 4A and 4B) electrically connected to the electronic component from among the plurality of solder balls and the second side may be shorter than a shortest distance (e.g., the third distance d3 of FIG. 4B) between the plurality of signal solder balls and the first side.

According to an embodiment, the length of the second side may be shorter than the length of the first side.

According to an embodiment, the blocking structure may include at least one blocking groove (e.g., the at least one blocking groove 451 of FIGS. 4A and 4B) extending into the surface of the printed circuit board.

According to an embodiment, the at least one blocking groove may include a plurality of blocking grooves (e.g., the plurality of blocking grooves 451a, 451b, and 451c of FIG 5B) spaced apart from each other along a direction parallel to the first side.

According to an embodiment, the blocking structure may include a blocking partition wall (e.g., the blocking partition wall 452 of FIGS. 6A, 6B, and 6C) extending in a direction in which the surface of the printed circuit board faces.

According to an embodiment, the printed circuit board may further include a supporting pad (e.g., the supporting pad 416 of FIGS. 6B and 6C) disposed between the first side and the plurality of solder balls. According to an embodiment, the blocking partition wall may be disposed on the supporting pad.

According to an embodiment, the blocking partition wall may extend from the surface of the printed circuit board to a surface of the electronic component (e.g., the surface 420b of FIG. 6B) facing the surface of the printed circuit board.

According to an embodiment, the electronic component may include a plurality of chips stacked along a direction in which the surface of the printed circuit board faces.

According to an embodiment, the plurality of solder balls may include a plurality of signal solder balls (e.g., the plurality of signal solder balls 431 of FIGS. 4A and 4B) electrically connecting the electronic component to the printed circuit board and at least one dummy solder ball (e.g., the at least one dummy solder ball 432 of FIGS. 4A and 4B) electrically disconnected from the electronic component. According to an embodiment, the resin may be spaced apart from the plurality of signal solder balls and may in contact with the at least one dummy solder ball.

According to an embodiment, the printed circuit board may further include at least one first conductive pad (e.g., the first conductive pad 415 of FIG. 5A), disposed on the surface of the printed circuit board, and being in contact with the at least some of the plurality of solder balls. According to an embodiment, the electronic component may further include at least one second conductive pad (e.g., the second conductive pad 421 of FIG. 5A), facing the surface of the printed circuit board, and being in contact with the at least some of the plurality of solder balls.

According to an embodiment, a ratio of an area of a portion of the surface of the printed circuit board that is in contact with the resin to an area of the surface of the printed circuit board may be 20% to 40%.

According to an embodiment, a thermal expansion coefficient of the resin may be different from a thermal expansion coefficient of the plurality of solder balls.

According to an embodiment, the printed circuit board may further include a third side (e.g., the third side 413 of FIGS. 4A and 4B), parallel to the first side, and perpendicularly connected to the second side. According to an embodiment, the resin may include a first cover region (e.g., the first cover region 441 of FIGS. 4A and 4B) disposed along the first side, and a second cover region (e.g., the second cover region 442 of FIGS. 4A and 4B), space apart from the first cover region, and disposed along the third side.

According to an embodiment, a semiconductor package (e.g., the semiconductor package 400 of FIGS. 4A and 4B) may comprise a printed circuit board (e.g., the printed circuit board 410 of FIGS. 4A and 4B) including a first side (e.g., the first side 411 of FIGS 4A and 4B), and a second side (e.g., the second side 412 of FIGS. 4A and 4B) perpendicular to the first side, a plurality of solder balls (e.g., the solder balls 430 of FIGS. 4A and FIG. 4B), disposed on a surface (e.g., the surface 410a of FIGS. 4A and 4B) of the printed circuit board, and spaced apart from the first side and the second side, an electronic component (e.g., the electronic component 420 of FIGS. 4A and 4B), including at least one circuit, and disposed on at least some of the plurality of solder balls, and a resin (e.g., the resin 440 of FIGS. 4A and 4B), disposed along the first side, and filling a portion of a space disposed between the surface of the printed circuit board and the electronic component, and wherein the printed circuit board may include a blocking structure (e.g., the blocking structure 450 of FIGS. 4A and 4B), disposed between the plurality of solder balls and the first side, and extending along the first side to separate the at least some of the plurality of solder balls from the resin.

According to an embodiment, the number of solder balls spaced apart from the first side by a shortest distance from among the plurality of solder balls may be smaller than the number of solder balls spaced apart from the second side by a shortest distance from among the plurality of solder balls.

According to an embodiment, a shortest distance (e.g., the fourth distance d4 of FIG. 4B) between a plurality of signal solder balls (e.g., the plurality of signal solder balls 431 of FIGS. 4A and 4B) electrically connected to the electronic component from among the plurality of solder balls and the second side may be shorter than a shortest distance (e.g., the third distance d3 of FIG. 4B) between the plurality of signal solder balls and the first side.

According to an embodiment, the blocking structure may include at least one blocking groove (e.g., the at least one blocking groove 451 of FIGS. 4A and 4B) extending into the surface of the printed circuit board.

According to an embodiment, the blocking structure may include a blocking partition wall (e.g., the blocking partition wall 452 of FIGS. 6A, 6B, and 6C) extending in a direction in which the surface of the printed circuit board faces.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a printed circuit board including a first side and a second side perpendicular to the first side;
a plurality of solder balls, disposed on a surface of the printed circuit board, and spaced apart from the first side and the second side;
an electronic component, including at least one circuit, and disposed on at least some of the plurality of solder balls; and
a resin, disposed along the first side, and filling a portion of a space disposed between the surface of the printed circuit board and the electronic component, and
wherein the printed circuit board includes a blocking structure, disposed between the plurality of solder balls and the first side, and extending along the first side to separate the at least some of the plurality of solder balls from the resin.

2. The electronic device of claim **1,**
wherein a number of solder balls spaced apart from the first side by a shortest distance from among the plurality of solder balls is smaller than a number of solder balls spaced apart from the second side by a shortest distance from among the plurality of solder balls.

3. The electronic device of any one of claim 1 and claim 2,
wherein a shortest distance between a plurality of signal solder balls electrically connected to the electronic component from among the plurality of solder balls and the second side is shorter than a shortest distance between the plurality of signal solder balls and the first side.

4. The electronic device of any one of claims 1 to 3,
wherein a length of the first side is longer than a length of the second side.

5. The electronic device of any one of claims 1 to 4,
wherein the blocking structure includes at least one blocking groove formed by recessing the surface of the printed circuit board.

6. The electronic device of claim 5,
wherein the at least one blocking groove includes a plurality of blocking grooves spaced apart from each other along a direction parallel to the first side.

7. The electronic device of any one of claims 1 to 6,
wherein the blocking structure includes a blocking partition wall protruding in a direction in which the surface of the printed circuit board faces.

8. The electronic device of claim 7,
wherein the printed circuit board further includes a supporting pad disposed between the first side and the plurality of solder balls, and
wherein the blocking partition wall is disposed on the supporting pad.

9. The electronic device of claim 7,
wherein the blocking partition wall is in contact with a surface of the electronic component that faces the surface of the printed circuit board.

10. The electronic device of any one of claims 1 to 9,
wherein the electronic component includes a plurality of chips stacked along a direction in which the surface of the printed circuit board faces.

11. The electronic device of any one of claims 1 to 10,
wherein the plurality of solder balls includes:
a plurality of signal solder balls electrically connecting the electronic component to the printed circuit board; and
at least one dummy solder ball electrically disconnected from the electronic component, and
wherein the resin is spaced apart from the plurality of signal solder balls and is in contact with the at least one dummy solder ball.

12. The electronic device of any one of claims 1 to 11,
wherein the printed circuit board further includes at least one first conductive pad, disposed on the surface of the printed circuit board, and being in contact with the at least some of the plurality of solder balls, and
wherein the electronic component further includes at least one second conductive pad that faces the surface of the printed circuit board, and is in contact with the at least some of the plurality of solder balls.

13. The electronic device of any one of claims 1 to 12,
wherein a ratio of an area of a portion of the surface of the printed circuit board that is in contact with the resin to an area of the surface of the printed circuit board is 20% to 40%.

14. The electronic device of any one of claims 1 to 13,
wherein a thermal expansion coefficient of the resin is different from a thermal expansion coefficient of the plurality of solder balls.

15. The electronic device of any one of claims 1 to 14,
wherein the printed circuit board further includes a third side, parallel to the first side, and perpendicularly connected to the second side, and
wherein the resin includes:
a first cover region disposed along the first side; and
a second cover region, space apart from the first cover region, and disposed along the third side.
